Europäisches Patentamt

European Patent Office

Office européen des brevets

(19)

(11) Veröffentlichungsnummer: **0 062 872**
**B1**

(12) **EUROPÄISCHE PATENTSCHRIFT**

(45) Veröffentlichungstag der Patentschrift:
12.09.84

(51) Int. Cl.³: **H 04 B 1/30**, H 03 D 1/22

(21) Anmeldenummer: 82102882.6

(22) Anmeldetag: 05.04.82

(54) Empfangssystem.

(30) Priorität: 07.04.81 DE 3114063

(43) Veröffentlichungstag der Anmeldung:
20.10.82 Patentblatt 82/42

(45) Bekanntmachung des Hinweises auf die Patenterteilung:
12.09.84 Patentblatt 84/37

(84) Benannte Vertragsstaaten:
AT CH DE FR GB IT LI NL

(56) Entgegenhaltungen:
DE - A - 2 902 952
US - A - 3 701 948

FUNKSCHAU, Heft 15, 1980 "Digitalisierung im
Fernsehempfänger" FRANZIS VERLAG GMBH,
München Seiten 41-44
FUNKSCHAU, Heft 20, 2. Oktober 1981, FRANZIS
VERLAG GMBH, München CHARLES SCHEPERS "Auf
dem Weg zum digitalen TV-Bildschirmspeicher" Seiten
87-89

(73) Patentinhaber: ANT Nachrichtentechnik GmbH,
Gerberstrasse 33, D-7150 Backnang (DE)

(72) Erfinder: Maurer, Robert, Prof.Dr.-Ing., Am Staden 11,
D-6600 Saarbrücken (DE)
Erfinder: Frank, Georg, Dipl.-Ing.,
Graf-Johann-Strasse 18, D-6600 Saarbrücken (DE)

(74) Vertreter: Schickle, Gerhard, Dipl.-Ing. et al, ANT
Nachrichtentechnik GmbH Patent- und Lizenzabteilung
Gerberstrasse 33, D-7150 Backnang (DE)

## Beschreibung

Durch die US-PS No 3 701 948 ist ein Empfangssystem bekannt, bestehend aus einem in analoger Technik realisierten Hochfrequenzteil mit Vorverstärker, zwei in Quadratur betriebenen Mischern, einem $\pi/2$-Phasenschieber und mit einem spannungsgesteuerten Oszillator, wobei das Hochfrequenzsignal durch Multiplikation mittels phasengeregelter Regelschleife direkt ins Basisband umgesetzt wird und den Mischern nachgeschaltete Tiefpässe störende Mischprodukte selektieren, sowie weiterhin bestehend aus einem dem Hochfrequenzteil nachgeschalteten Niederfrequenzteil, dass das Niederfrequenzteil in digitaler Technik realisiert ist. Die US-PS No 3 701 948 deckt die Oberbegriffe der Hauptansprüche 1 bis 3.

Aufgabe der Erfindung ist es, ein derartiges Empfangssystem mit digitaler Signalverarbeitung aufzuzeigen, bei dem keine Zwischenfrequenz (ZF) auftritt und sowohl der Hochfrequenzteil als auch der Niederfrequenzteil des Empfangssystems jeweils in der optimalen Technik realisiert wird.

Gelöst wird dies durch die in den Hauptansprüchen 1 bis 3 jeweils angegebenen Merkmale.

Vorteilhafte Weiterbildungen der Erfindung können nach den in den Unteransprüchen aufgezeigten Schaltungen aufgebaut werden.

Im folgenden sollen die Erfindung und die mit ihr erzielbaren Vorteile anhand von Ausführungsbeispielen näher erläutert werden.

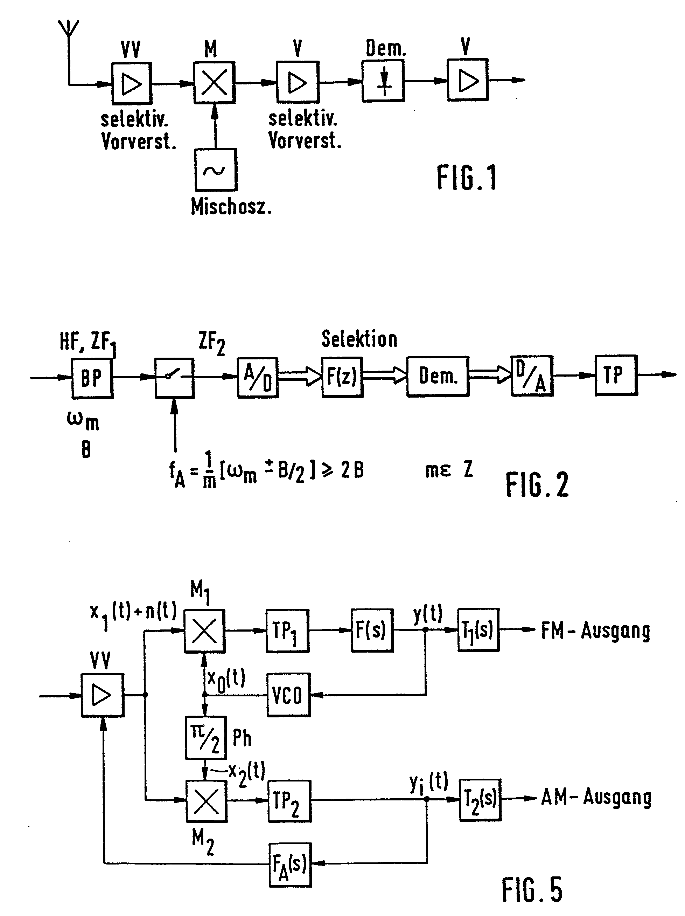

Die heute gebräuchlichen Empfänger für Hörfunk und Fernsehen beruhen auf der Struktur der Überlagerungsempfänger, dessen Blockschaltbild in Fig. 1 dargestellt ist. Das Empfangssignal wird über einen selektiven, in der Mittenfrequenz variierbaren, rauscharmen Vorverstärker einem Mischer zugeführt und auf eine konstante ZF-Frequenz umgesetzt. Danach folgt die eigentliche Selektion und die Demodulation. Dieses Empfängerkonzept erfordert einen sehr frequenzkonstanten Mischoszillator und für die Selektion hochselektive, im Abgleich aufwendige Bandfilter. Das Verfahren war lange Zeit den technologischen Möglichkeiten angepasst und hat inzwischen einen hohen Entwicklungsstand erreicht.

### Randbedingungen der digitalen Signalverarbeitung

Digitale Systeme zur Signalverarbeitung arbeiten mit quantisierten, digitalisierten Abtastwerten einer Zeitfunktion. Die Form der Abtastimpulse ist dabei von entscheidender Bedeutung hinsichtlich unerwünschter Verzerrungen im Spektrum der abgetasteten Funktion. Im Idealfall handelt es sich bei der Abtastfunktion um eine periodische Folge von Dirac-Impulsen. Das abgetastete Signal lässt sich dann wie folgt angeben

$$x_a(t) = \sum_{\upsilon = -\infty}^{\infty} x(\upsilon \cdot T_o) \cdot a(t - \upsilon T_o)$$

Die Fouriertransformierte dieses Signals lautet

$$x_a(j\omega) = \omega_o \sum_{\upsilon = -\infty}^{\infty} x(j\omega - j\upsilon\omega_o); \quad \omega_o = \frac{2\pi}{T_o}$$

Die Abtastfrequenz ist dabei $f_o = 1/T_o$. Aus der Darstellung für die Fouriertransformierte lässt sich entnehmen, dass jede Abtastung eine periodische Wiederholung des Urspektrums bewirkt. Gleichzeitig kann dadurch auch ein Signal in der Frequenzlage umgesetzt werden. Die Abtastfrequenz muss bezüglich der Bandbreite B des abzutastenden Signals die Bedingung

$$\omega_o \geqq 2B$$

erfüllen. Eine Verletzung dieser als Abtasttheorem bekannten Beziehung verursacht eine Überlappung der einzelnen Anteile im Spektrum der abgetasteten Funktion, die ursprüngliche Zeitfunktion kann dann nicht mehr rekonstruiert werden. Deshalb muss jedes Signal vor der Abtastung bandbegrenzt werden.

Bei realer Abtastung mit einem Abtast-Halteglied erhält man eine periodische Wiederholung des mit

$$\frac{\sin \frac{\omega T}{2}}{\frac{\omega T}{2}} \cdot e^{-j\omega T/2}$$

verzerrten ursprünglichen Spektrums. Die dabei auftretende Zeitverzögerung muss beim Aufbau digitaler Regelkreise berücksichtigt werden, um die Stabilität nicht zu gefährden. Des weiteren verursachen Schwankungen in der Dauer T des Abtastintervalls (Schliessfehler) zusätzliche Amplitudenverzerrungen.

An die Präzision der Abtastung und die Grenzfrequenz der beteiligten Komponenten sind deshalb hohe Anforderungen zu stellen. Eine totale Digitalisierung eines Empfängers ist somit wenig sinnvoll.

### Strukturen asynchroner digitaler Empfänger

#### Digitale Version der Überlagerungsempfänger

Das Blockschaltbild aus Fig. 2 besitzt eine dem Überlagerungsempfänger entsprechende Struktur. Ein breites Empfangsband wird in der HF- oder in der ZF-Ebene mit analogen Filtern vorselektiert. Die anschliessende Abtastung erfordert eine entsprechend der breitbandigen Vorselektion hohe Abtastrate. Mit der Abtastung kann eine gleichzeitige Abwärtsmischung in eine neue ZF-Ebene verbunden werden. Das eigentliche Nutzsignal wird auf digitale Weise selektiert (digitaler Bandpass). Es entfällt damit der schwierige Abgleich herkömmlicher Bandfilter. Die so erreichbare hohe Selektion erfordert, je nach Filtergrad, in Verbindung mit der hohen Bandbreite des nur schwach selektierten Eingangssignals extrem schnelle digitale Bausteine. Das Konzept ist somit den technologischen Gegebenheiten nicht angepasst.

Die Demodulation kann z.B. im Fall eines amplitudenmodulierten Signals durch die einfach zu realisierende Betragsbildung und eine nochmalige digitale Tiefpassfilterung erfolgen, wobei die im analogen Fall übliche Methode zur Demodulation digital nachgebildet wird.

Ausser der hohen Abtastrate und Rechengeschwindigkeit besitzt dieses System weiterhin den Nachteil, dass eine Verstimmung zwischen Trägerfrequenz und Mittenfrequenz des Bandfilters Verzerrungen im demodulierten Signal verursachen – siehe auch nachfolgender Abschnitt.

*Asynchroner Digitalempfänger mit Analog-Digital-Wandlung im Basisband*

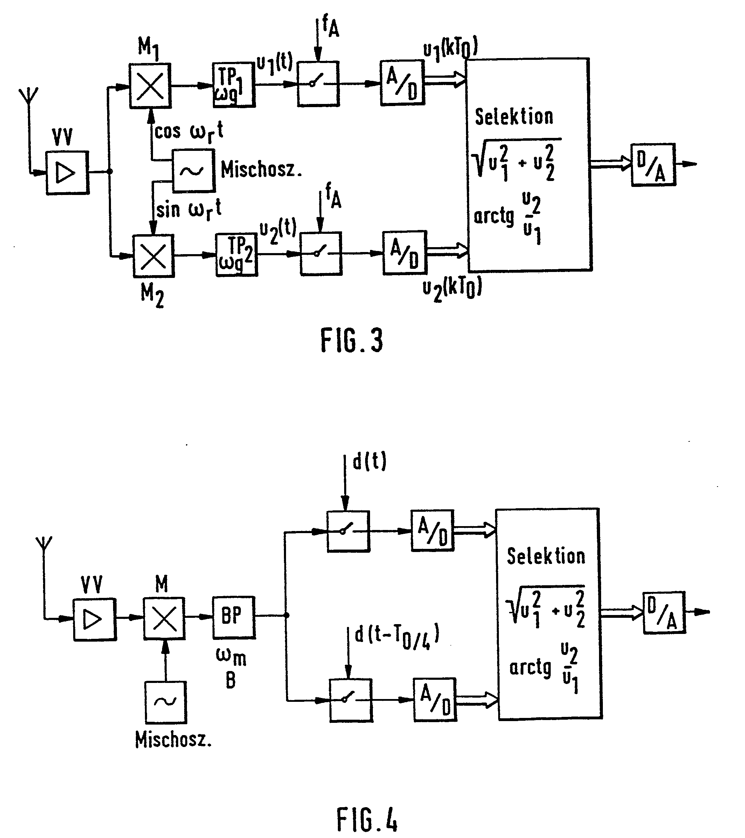

Der asynchrone Empfang mit Demodulation im Basisband (ZF=0) erfordert die gleichzeitige Abwärtsmischung mit Hilfe zweier orthogonaler Signale. Die Struktur dieses Empfängers, in Fig. 3 dargestellt, ist bereits bekannt [3].

Das Eingangssignal sei:

$$x_1(t) = a_1(t) \cdot \cos(\omega_T t + \varphi(t)).$$

Dann erhält man nach der Multiplikation mit

$$x_c(t) = a_o \cdot \cos(\omega_T t + \Delta\omega t + \varphi_1(t))$$
$$x_s(t) = a_o \cdot \sin(\omega_T t + \Delta\omega t + \varphi_1(t))$$

und nach der Tiefpassfilterung, bei der die Anteile bei der doppelten Trägerfrequenz eliminiert und die Bandbreite des Mischproduktes auf die für die nachfolgende Abtastung erlaubte Bandbreite begrenzt wird, die beiden Signale

$$u_1(t) = k_m \frac{a_o}{2} a_1(t) \cdot \cos(\Delta\omega t + \varphi_1(t) - \varphi(t))$$

$$u_2(t) = k_m \frac{a_o}{2} a_1(t) \cdot \sin(\Delta\omega t + \varphi_1(t) - \varphi(t))$$

Mit $\Delta\omega$ wird der Fall berücksichtigt, dass die Trägerfrequenz nicht exakt mit der Frequenz des Mischoszillators übereinstimmt. Diese beiden zu den Zeitpunkten $k \cdot T_o$ abgetasteten Signale können im Digitalteil des Empfängers auf die exakte Signalbandbreite begrenzt werden (Selektion). Bei Frequenzversatz $\Delta\omega$ werden hier die vom oberen und unteren Seitenband herrührenden Anteile des Signalspektrums jeweils unterschiedlich gefiltert, was im demodulierten Signal nicht mehr rückgängig zu machende Verzerrungen der Amplitude und Phase verursacht. Solange jedoch durch die Filterung, beschrieben durch die Faltung mit der Gewichtsfunktion $h(kT_o)$ des Digitalfilters, die beiden Signale $u_1$ und $u_2$ infolge Frequenzversatz noch nicht berührt werden, d.h.

$$u_1(kT_o)*h(kT_o) = k_m \frac{a_o}{2} a_1(kT_o) \cdot \cos(\Delta\omega kT_o + \varphi_1(kT_o) - \varphi(kT_o))$$

$$u_2(kT_o)*h(kT_o) = k_m \frac{a_o}{2} a_1(kT_o) \cdot \sin(\Delta\omega kT_o + \varphi_1(kT_o) - \varphi(kT_o))$$

erfüllt ist, lässt sich die konventionelle Hüllkurve des Eingangssignals durch Berechnen von

$$p(kT_o) = + \sqrt{u_1^2(kT_o) + u_2^2(kT_o)} = k_m \frac{a_o}{2} \left| a_1(kT_o) \right|$$

gewinnen. Die Demodulation eines winkelmodulierten Signals erfolgt unter den gleichen Randbedingungen durch Berechnen von

$$\Phi(kT_o) = \arctan \frac{u_2(kT_o)}{u_1(kT_o)} = \Delta\omega kT_o - \varphi(kT_o) + \varphi_1$$

$$\dot{\Phi}(kT_o) = \Omega(kT_o) = \Delta\omega - \dot{\varphi}(kT_o) + \dot{\varphi}_1(kT_o)$$

Die Momentanphase $\Phi(kT_o)$ ist durch das Phasenrauschen $\varphi_1$ des Mischoszillators und bei Frequenzversatz durch einen konstant anwachsenden Term verfälscht, welcher u.a. Schwierigkeiten hinsichtlich des begrenzten Wertebereichs verursacht. Die Momentanfrequenz $\Omega$ wird durch Differenzieren der Momentanphase gewonnen. Sie ist um $\Delta\omega - \dot{\varphi}_1$ verfälscht. Fehlende Synchronität und Phasenrauschen des Mischoszillators werfen also erhebliche Probleme auf.

Eine weitere Realisierung des asynchronen Hybridempfängers ist in Fig. 4 dargestellt. Es entfällt die Abwärtsmischung mit zwei orthogonalen harmonischen Signalen. Statt dessen wird das Empfangssignal in der ZF-Ebene vorselektiert und mit zwei zeitlich (um eine viertel Taktdauer) verschobenen Impulsfolge abgetastet. Die Abtastung bewirkt eine gleichzeitige Abwärtsmischung ins Basisband mit Zwischenfrequenz Null, wenn die Abtastrate

$$r = \frac{\omega_m}{m} \geq 2B \qquad m\varepsilon \, \mathbb{Z}$$

gewählt wird. Damit die Orthogonalität der beiden Signale $u_1$ und $u_2$ gesichert wird, muss noch m ungerade gewählt werden. Der weitere Aufbau entspricht der oben dargestellten Struktur und verursacht damit auch die gleichen Schwierigkeiten.

*Synchronempfänger mit digitaler Signalverarbeitung im Basisband*

*Prinzip des direktmischenden Synchronempfängers*

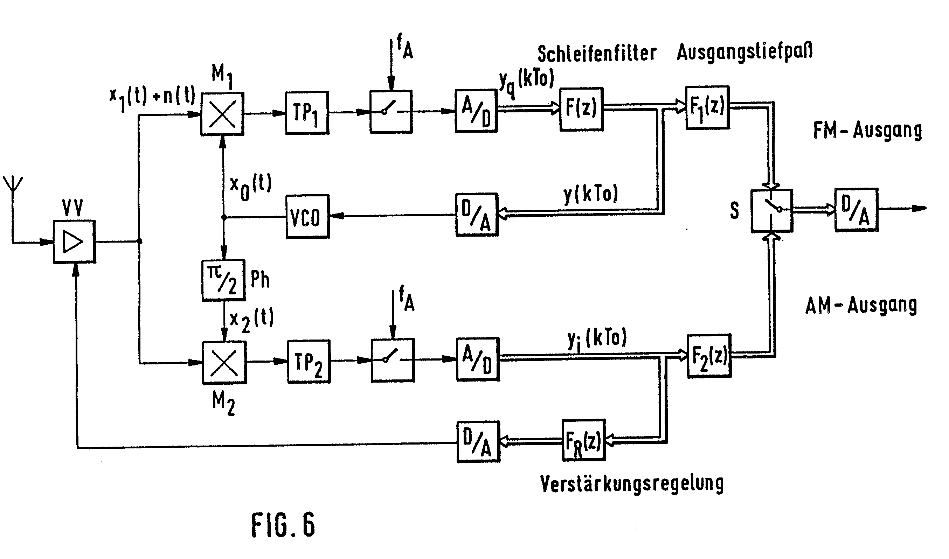

Am Beispiel von Fig. 5 soll das Prinzip eines Synchronempfängers erläutert werden. Wesentlicher Bestandteil dieses Systems ist eine phasengerastete Regelschleife (phase-locked-loop, PLL), mit welcher ein spannungsgesteuerter Oszillator (voltage-controlled-oscillator, VCO) in Frequenz und Phase mit einem zu empfangenden Signal synchronisiert wird. Mit diesem synchronisierten Signal wird das Empfangssignal unter Umgehung der ZF-Ebene direkt im Basisband herabgemischt und synchron demoduliert. Ein nachfolgender Demodulator wie z.B. beim Überlagerungsempfänger oder beim Empfänger aus Fig. 4 entfällt somit. Durch die Synchrondemodulation ergibt sich ein geringerer Schwellwert.

Wird das verrauschte Eingangssignal mit

$$x_1(t) + n(t) = a_1(t) \cdot \sin(\omega_T t + \varphi_T) + n(t)$$

angesetzt, und das VCO-Signal mit

$$x_o(t) = a_o \cdot \cos(\omega_o t + \varphi_o)$$

wobei die Phase $\varphi_o(t)$ durch die Beziehung

$$\varphi_o(t) = k_o \, _o\!\int^t y(\tau) \, d$$

gegeben ist, so erhält man die bekannte Differentialgleichung des PLL [5]:

$$\frac{d\Phi}{dt} = -k_o \left( k_m \frac{a_1 a_2}{2} \cdot \sin(\Delta\omega t + \Phi) + n'(t) \right)*h(t) + \frac{d\varphi_T}{dt}$$

$$\Phi = \varphi_T - \varphi_o$$
$$\Delta\omega = \omega_T - \omega_o$$

Der PLL besitzt die Eigenschaft, einen gewissen Bereich der Verstimmung $\Delta\omega$ selbsttätig auszuregeln (Fangbereich) und den einmal erreichten synchronen Zustand zu bewahren. Im synchronen Zustand $\Delta\omega$=o lässt sich bei kleinem Phasenfehler $\Phi(t)$ die Sinus-Funktion durch ihr Argument ersetzen. Aus der damit entstandenen linearen Differentialgleichung kann die Tiefpass-Übertragungsfunktion des linearisierten PLL abgeleitet werden:

$$H(s) = \frac{\varphi_o(s)}{\varphi_T(s)} = \frac{\omega_s F(s)}{s + \omega_s F(s)}$$

Darin ist

$$\omega_s = \frac{a_1 a_o}{2} k_m \cdot k_o$$

die statische Schleifenverstärkung des PLL, welche vom Eingangspegel $a_1$ abhängig ist. Die Abhängigkeit vom Eingangspegel erfordert eine Regelung der Schleifenverstärkung, um ein definiertes Systemverhalten und die Stabilität des PLL zu gewährleisten [1].

Zwischen dem Steuersignal y(t) des VOC und der Phase des Eingangssignals kann unter Berücksichtigung des Rauschens n'(t) der Zusammenhang

$$y(s) = \frac{1}{k_o} \cdot s \cdot H(s) \cdot \varphi_T(s) + \frac{1}{\omega_s} \cdot s \ H(s) \cdot N'(s)$$

angegeben werden. Stellt $\varphi_T(t)$ die Phase eines mit dem Signal v(t) frequenzmodulierten Trägers dar, so gilt wegen

$$\varphi_T(s) = \Delta\Omega \frac{1}{s} \cdot V(s)$$

für das Demodulationsverhalten des PLL

$$y(s) = \frac{\Delta\Omega}{k_o} \cdot H(s) \cdot V(s) + \frac{s}{\omega_s} H(s) \cdot N(s)$$

Wenn die Bandbreite der Übertragungsfunktion H(s) genügend gross gewählt wird, setzt sich das demodulierte Signal y(t) aus einem dem modulierenden Signal v(t) direkt proportionalen Anteil und einem Rauschanteil zusammen. Zur Begrenzung dieses Rauschanteils ist eine ausgangsseitige Bandbegrenzung erforderlich $(T_1(s))$.

Mit dem um 90° phasenverschobenen VCO-Signal

$$x_2(t) = a_o \cdot \sin(\omega_o t + \varphi_o)$$

ist eine synchrone Demodulation der Trägeramplitude $a_1(t)$ möglich. Aus dem Produkt von $x_1$ und $x_2$ erhält man nach der Tiefpassfilterung zur Elimination der Anteile bei der doppelten Trägerfrequenz das Signal

$$y_i(t) = \frac{k_m a_o}{2} \cdot a_1(t) \cdot \cos_\varphi(t) \sim a_1(t), \forall |\varphi| \ll 1°$$

welches für kleine Phasenfehler direkt proportional der Trägeramplitude ist. Es ist ausserdem im Fall eines amplitudenmodulierten Signals die demodulierte Information. $Y_i(t)$ wird zur automatischen Verstärkungsregelung und damit zur Regelung der Schleifenverstärkung verwendet. Das Regelfilter $F_R(S)$ ist dabei so schmalbandig zu wählen, dass die Zeitkonstante der Verstärkungsregelung mindestens um den Faktor 10 grösser ist als die Zeitkonstante des Phasenregelkreises.

*Grundstruktur des neuen Empfangssystems*

Die Struktur des bekannten direkt mischenden, synchronen Empfängers aus Fig. 5 lässt sich in einen HF-Teil und in einen davon getrennten NF-Teil zerlegen. Das neue Empfangssystem stellt den Hybridenaufbau eines synchronen Homodynempfängers mit dem in Analogtechnik realisierten HF-Teil (Vorverstärker, Mischer, spannungsgesteuerter Oszillator, Phasenschieber) und dem digital realisierten NF-Teil (Schleifenfilter, Ausgangstiefpass, Verstärkungsregelung) dar. Anhand der Fig. 6 soll diese Schaltung erläutert werden.

Das Eingangssignal wird einem Vorverstärker VV zugeführt. Der Verstärkerausgang spaltet sich in zwei Zweige auf. Der eine in der Figur oben eingezeichnete Zweig besteht aus dem Mischer $M_1$ mit nachgeschaltetem Tiefpass $TP_1$ und dem darauffolgenden Baustein für die mit der Abtastfrequenz $f_A$ erfolgende Signalabtastung. Der Ausgang der genannten Abtaststufe führt zu einem Analog-Digital-Wandler A/D, dessen Ausgangssignal einem Schleifenfilter F(z) zugeführt wird. Der Ausgang dieses Schleifenfilters führt zu dem zugehörigen Ausgangstiefpass $F_1(z)$ und andererseits über einen Digital-Analog-Wandler D/A zu dem spannungsgesteuerten Oszillator VCO, dessen Ausgangssignal $x_o(t)$ dem Mischer $M_1$ zugeführt wird. Gleichzeitig wird das Ausgangssignal des VCO über einen die Phase um $\pi/2$ drehenden Phasenschieber Ph geleitet, dessen Ausgangssignal $x_2(t)$ den Mischer $M_2$ beaufschlagt.

Der andere Zweig auf der Ausgangsseite des Vorverstärkers VV besteht aus einem Mischer $M_2$ und dem Tiefpass $TP_2$. Das durch diesen Tiefpass selektierte Signal führt zu einer Abtaststufe, die das vorhandene Signal mit der Frequenz $f_A$ abtastet.

Der Ausgang dieser Abtaststufe führt über einen Analog-Digital-Wandler A/D. Sein Ausgangssignal $y_i(kT_o)$ wird auf einen Ausgangstiefpass $F_2(z)$ gegeben. Das zuletzt genannte Signal dient gleichzeitig der Verstärkungsregelung, dargestellt durch die Stufe $F_R(z)$, deren Ausgangssignal nach Umwandlung in einen Digital-Analog-Wandler D/A beim dargestellten Ausführungsbeispiel dem Vorverstärker VV zugeführt wird.

Es sei bereits hier darauf hingewiesen, dass dieses Regelsignal auch dem spannungsgesteuerten Oszillator VCO oder den beiden Tiefpässen $TP_1$ und $TP_2$ zugeführt werden kann.

Aus den an den beiden Ausgangstiefpässen $F_1(z)$ bzw. $F_2(z)$ vorhandenen Signalen kann über einen Schalter S das gewünschte amplituden- oder frequenzmodulierte Signal ausgewählt werden und über einen nachgeschalteten Digital-Analog-Wandler D/A zum analogen NF-Signal zurückverwandelt werden.

Das Systemverhalten dieser linearisierten analog-digitalen (hybriden) phasengerasteten Regelschleife PLL im Empfangssystem gemäss Fig. 6 ist sowohl im Laplace-Bereich als auch unter Verwendung der Z-Transformation darstellbar. Die Bestimmung des optimalen digitalen Schleifenfilters F(z) nach der Optimalfiltertheorie von Wiener zeigt, dass bei Berücksichtigung der durch die Abtastung und die Digital-Wandlung verursachten Zeitverzögerung das optimale digitale Schleifenfilter einen höheren Grad besitzt als im entsprechenden analogen Fall [5].

Dieses neue Empfängerkonzept nach Fig. 6 kann folgendermassen charakterisiert werden:

Die Synchrontechnik unter Verwendung einer phasengerasteten Regelschleife gewährleistet eine phasengenaue synchrone Abwärtsmischung des Empfangssignals ins Basisband.

Es gibt keine Zwischenfrequenz und somit ergeben sich keine Probleme mit der Spiegelfrequenz (Spiegelfrequenz ist gleich der Empfangsfrequenz).

Es ist keine Vorselektion erforderlich. Die Bandbegrenzung erfolgt im Basisband durch die den Mischern $M_1$, $M_2$ folgenden Tiefpässe $TP_1$, $TP_2$. Deren Bandbreite wird durch die Abtastfrequenz bestimmt.

Eine weitere Bandbegrenzung wird durch die Übertragungsfunktion der phasengerasteten Regelschleife verursacht.

Das Ausgangssignal des spannungsgesteuerten Oszillators VCO muss sehr arm an Oberwellen sein, um bei fehlender Vorselektion einen Mehrfachempfang zu verhindern.

Die Mischer müssen in einem weiten Dynamikbereich verzerrungsfrei arbeiten [2].

Mit der Synchrondemodulation ist ein niedrigerer Schwellwert erreichbar als mit herkömmlichen Demodulatoren.

Die Analogtechnik ist die einzige zur Verfügung stehende Technologie zum Aufbau der Systemkomponenten, die hochfrequente Signale verarbeiten müssen, wie regelbarer Vorverstärker VV, Mischer, spannungsgesteuerter Oszillator VCO und Phasenschieber Ph. Durch Verlegen der Abtastung ins Basisband entfällt eine HF-seitige selektive Vorfilterung.

Die digitale Realisierung des Niederfrequenzteils verlangt die spektrale Begrenzung des Eingangssignals vor der Abtastung und eine Analog-Digital-Wandlung. Die dadurch verursachten Phasenfehler müssen bei der Wahl des digitalen Schleifenfilters berücksichtigt werden.

Digitale Systeme bleiben in der Anwendung grundsätzlich auf den Niederfrequenzbereich beschränkt. Die Grenzfrequenz erhöht sich aber langsam infolge technologischer Fortschritte, so dass in absehbarer Zeit auch die Verarbeitung des FBAS-Signals beim Fernsehen möglich sein wird. Die digitale Verarbeitung ermöglicht eine vollständige Integration.

Die Eigenschaften des digitalen NF-Teils (Filterung, Steuerung) sind programmierbar.

Bei einer Serienfertigung tauchen keine Toleranzprobleme auf. Abgleicharbeiten entfallen.

Die Aussteuerbarkeit ist begrenzt. Sie wird durch die Art der Zahlendarstellung und die Anzahl der Quantisierungsstufen bestimmt. Deshalb ist eine Verstärkungsregelung im Analogteil erforderlich.

### Struktur für AM-, FM- und PM-Empfänger

Die allgemeine Grundschaltung aus Fig. 6 ist sowohl für den Empfang von amplitudenmodulierten Signalen als auch für den Empfang von winkelmodulierten Signalen geeignet. Der in der Grundstruktur enthaltene PLL muss für den jeweiligen Anwendungsfall spezialisiert, d.h. programmiert werden. Im Fall von zweiseitenbandamplitudenmodulierten Signalen mit Träger muss der PLL so schmalbandig ausgelegt werden, dass er nur auf den gegebenenfalls verrauschten Träger synchronisiert (Schmalband-PLL). Das synchrondemodulierte Nutzsignal steht im IN-PHASE-ZWEIG zur Verfügung. Die Selektion erfolgt mit dem Ausgangstiefpass $F_2(z)$.

Frequenzmodulierte Signale erfordern in der Schaltung gemäss Fig. 6 einen Breitband-PLL. Das Schleifenfilter und die statische Schleifenverstärkung müssen so dimensioniert werden, dass der PLL zum einen den maximalen Frequenzhub ausregeln kann, und andererseits das Nutzsignal in seiner ganzen Bandbreite unverzerrt demoduliert wird. Das Ausgangssignal $y(kT_0)$ steht im Quadraturzweig zur Verfügung.

Ein Tiefpass $F_1(z)$, dessen Grenzfrequenz gleich der höchsten NF-Frequenz des demodulierten Nutzsignals ist, dient zur Rauschoptimierung.

Phasenmodulierte Signale mit geringem Phasenhub werden mit einem Schmalband-PLL demoduliert. Die Grenzfrequenz der Übertragungsfunktion des PLL muss kleiner sein als die kleinste Nutzsignalfrequenz. Das demodulierte Signal wird vor dem Schleifenfilter F(z) abgegriffen.

### Synchroner Hybridempfänger für PSK- und ZSB-Signale ohne Träger

Amplituden- und 2-PSK-modulierte Signale sind in der Form

$$x_1(t) = v(t) \cdot \sin(\omega_T t + \varphi_T)$$

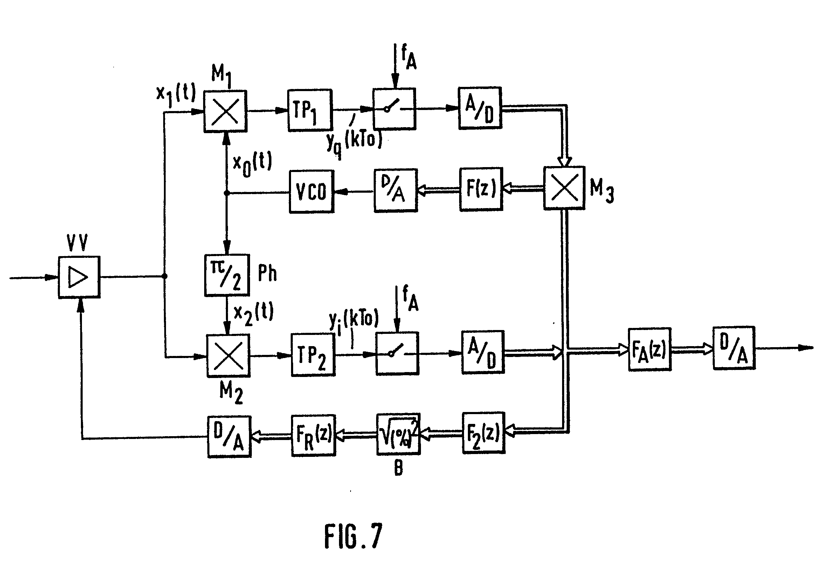

darstellbar, wobei v(t) eine mittelwertfreie Zeitfunktion ist. Das übertragende Signal besitzt somit keinen Träger. Die für den Empfang dieser Signale geeignete Synchronempfängerstruktur ist in Fig. 7 dargestellt.

Das auf den Vorverstärker VV eingespeiste Eingangssignal wird am Ausgang des Verstärkers wieder auf zwei Zweige aufgeteilt. Der eine Zweig besteht wie bei der in der Fig. 6 beschriebenen Schaltung aus der Serienschaltung eines Mischers $M_1$, eines Tiefpasses $TP_1$ und einer Abtasteinrichtung v mit nachgeschaltetem Analog-Digital-Wandler A/D. Das Ausgangssignal dieses Wandlers wird nun dem einen Eingang eines weiteren Mischers $M_3$ zugeführt.

Der zweite Zweig besteht analog der Schaltung gemäss der Fig. 6 aus der Serienschaltung eines Mischers $M_2$, eines Tiefpasses $TP_2$, einer Abtasteinrichtung $f_A$ mit nachgeschaltetem Analog-Digital-Wandler A/D, der zu einem zweiten Eingang des genannten Mischers $M_3$ führt. Der Ausgang des Mischers $M_3$ ist mit dem erforderlichen Schleifenfilter F(z) verbunden, dessen Ausgangssignal einem Digital-Analog-Wandler D/A zugeführt wird, der seinerseits den spannungsgesteuerten Oszillator VCO speist. Der Ausgang des Oszillators VCO führt zum einen mit seinem Ausgangssignal $x_o$ direkt zum Mischer $M_1$ und zum anderen über einen die Phase um $\pi/2$ drehenden Phasenschieber Ph zum Mischer $M_2$.

Der Ausgang des Analog-Digital-Wandlers A/D des zweiten Zweiges ist mit einem Ausgangstiefpass $F_A(z)$ verbunden, der seinerseits über einen Digital-Analog-Wandler D/A das gewünschte analoge NF-Signal abgibt.

Die Regelinformation zur Verstärkungsregelung wird gewonnen, indem das Ausgangssignal $y_i$ des zweiten Zweiges nach einer Tiefpassfilterung $F_2(z)$ durch eine Betragsbildung B gleichgerichtet wird. Im dargestellten Ausführungsbeispiel führt dieses Signal nach dem Regelfilter $F_R(z)$ und dem Digital-Analog-Wandler D/A auf den Vorverstärker VV.

Die beiden ins Basisband hinabgemischten Quadratursignale sind

$$y_q(t) = k_m \frac{a_o}{2} \cdot v(t) \cdot \sin \Phi$$

$$y_i(t) = k_m \frac{a_o}{2} \cdot v(t) \cdot \cos \Phi$$

Nach einer weiteren Multiplikation und Tiefpassfilterung steht das Signal

$$z(t) = (k_m \frac{a_o}{2})^2 \, v^2(t) * h(t) \cdot \sin 2\Phi$$

zur Verfügung. Es ist nicht mehr vom Vorzeichen der Funktion v(t) abhängig. Die Costas-Loop-Struktur bezieht die zur Synchrondemodulation notwendige Information über Mittenfrequenz und Phasenlage aus den Seitenbändern.

*Synchroner Hybridempfänger für Rest- und Einseitenbandsignale mit Träger*

Restseitenbandsignale mit Träger sind in der Form

$$x(t) = s_{ZSE} + x_{ESB} + x_{tr} =$$
$$= (v(t) \cdot \cos \omega_o t)_{ZSB} + \frac{1}{2} (s(t) \cdot \cos \omega_o t \pm$$
$$\pm \hat{s}(t) \cdot \sin \omega_o t)_{ESB} + a_1 \cdot \cos \omega_o t$$

darstellbar, wobei

$$\hat{s}(t) = \mathcal{H} (s(t))$$

die Hilbert-transformation bezeichnet. Das Pluszeichen steht für das obere, das Minuszeichen für das untere Seitenband. Multiplikation dieses Signals mit den beiden orthogonalen VCO-Signalen (Phasenfehler $\Phi$ = o angenommen)

$$x_o = a_o \cdot \sin \omega_o t$$
$$x_1 = a_o \cdot \cos \omega_o t$$

liefert nach der Tiefpassfilterung das Ergebnis

$$y_i(t) = \frac{a_1 a_o}{2} + v(t) \frac{a_o}{2} + s(t) \frac{a_o}{4}$$

$$y_q(t) = \pm \hat{s}(t) \frac{a_o}{4}$$

Der Einfachheit halber werde die Mischerkonstante $k_m = 1$ gesetzt. Wird nun $y_q(t)$ Hilbert-transformiert

$$\hat{y}_q(t) = \mathcal{H} (\pm \hat{s}(t)) = \quad s(t)$$

dann lässt sich durch Addition von $y_i$ und $\hat{y}_q$ das obere Seitenband eliminieren, während ein unteres Seitenband mit der gleichen Leistungsverstärkung wie das Zweiseitenbandsignal übertragen wird. Bei Subtraktion bleibt das obere Seitenband erhalten, und das untere wird zu Null.

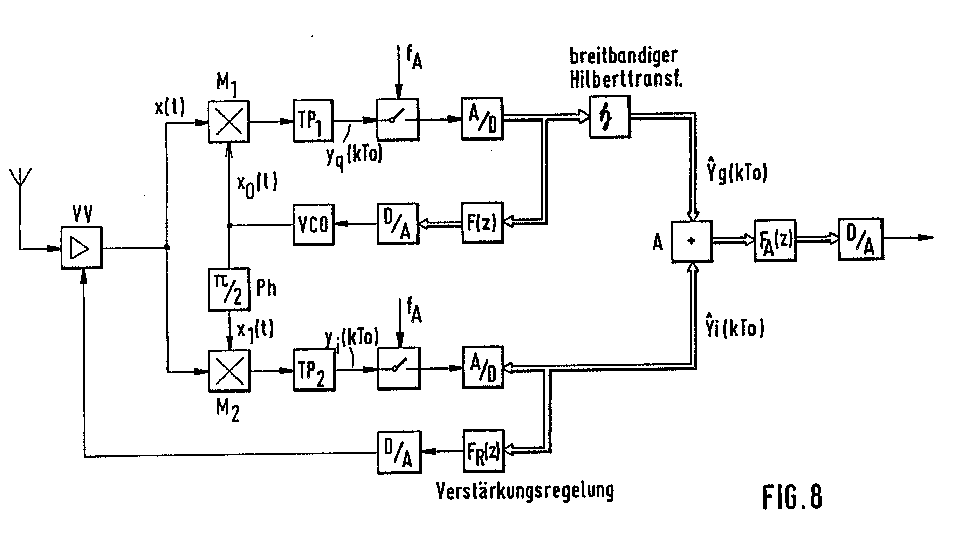

Die hierfür geeignete Schaltung ist in der Fig. 8 dargestellt. Auch hier wird das Eingangssignal nach entsprechender Vorverstärkung in VV auf zwei Zweige aufgeteilt. Der eine beinhaltet die Serienschaltung eines Mischers $M_1$ mit einem Tiefpass $TP_1$, einer Abtastvorrichtung $f_A$ und dem nachgeschalteten Analog-Digital-Wandler A/D. Dessen Ausgang führt zu einem breitbandigen Hilbert-Transformator $\mathcal{H}$ und gleichzeitig über ein Schleifenfilter F(z) und einen Digital-Analog-Wandler D/A auf einen spannungsgesteuerten Oszillator VCO. Dessen Ausgangssignal $x_o$ wird zum Mischer $M_1$ und gleichzeitig auf einen die Phase um $\pi/2$ drehenden Phasenschieber Ph geführt, dessen Ausgangssignal $x_1$ dem Mischer $M_2$ zugeführt wird. Dieser Mischer $M_2$ bildet den zweiten Zweig zusammen mit dem nachgeschalteten Tiefpass $TP_2$, der Abtasteinrichtung $f_A$, dem darauffolgenden Analog-Digital-Wandler A/D, dessen Ausgangssignal $y_i(kT_o)$ zusammen mit dem Ausgangssignal $\hat{y}_q$ einem Addierer A zugeführt, dessen Ausgang mit einem gemeinsamen Ausgangstiefpass $F_A(z)$ verbunden ist, der seinerseits zu dem nachgeschalteten Digital-Analog-Wandler D/A führt. An dessen Ausgang ist das gewünschte analoge NF-Signal abgreifbar.

Die erforderliche Verstärkungsregelung wird gebildet durch die zum A/D-Wandler und Addierer A angeschlossene Regelschleife, bestehend aus der Regeleinheit $F_R(z)$ mit nachfolgendem Digital-Analog-Wandler D/A. Beim dargestellten Ausführungsbeispiel wird das danach gewonnene Regelsignal dem Vorverstärker VV zugeführt.

Wie bereits anhand der Fig. 6 beschrieben, kann das Regelsignal bei der Schaltung gemäss Fig. 7 und auch der Schaltung gemäss Fig. 8 hiervon abweichend entweder dem spannungsgesteuerten Oszillator VCO zugeführt werden oder gleichzeitig den beiden Tiefpässen $TP_1$ und $TP_2$.

Die Empfängerstruktur nach Fig. 8 ist in der Lage, Einseitenband- und Restseitenbandsignale (z.B. Fernsehsignal) synchron zu demodulieren. Unter Einbeziehung eines Breitbandphasenschiebers (realer Hilbert-Transformator) mit der Bandbreite des Einseitenbandsignals lässt sich das unerwünschte Seitenband unterdrücken, ohne dass HF-seitig eine Einseitenbandfilterung vorgenommen wird. Algorithmen zur digitalen Hilbert-Transformation sind bekannt [6], erfordern aber je nach Genauigkeit und Verhältnis von oberer zu unterer Grenzfrequenz einen hohen Rechenaufwand.

1. Maurer, R.; Hoffmann, M.
Demodulatorschaltung mit Regelkreis
Patentanmeldung, AZ. P 28 53 890.1
Saarbrücken, Nov. 1978

2. Maurer, R.; Blum, A.; Hoffmann, M.
Direktmischendes Empfangssystem
Patentanmeldung, AZ. P 29 02 952.5
Saarbrücken, Dez. 1978

3. Schaller, W.
Digitaler Empfänger
Kolloquiumsvortrag am 25.01.1980 am Lehrstuhl für Hoch- und Höchstfrequenztechnik der Universität des Saarlandes

4. Viterbi, A. J.
Principles of Coherent Communication
McGraw-Hill, New York 1966

5. Gupta, S. C.
On optimum Digital Phase-Locked Loop
IEEE Trans. Com. Techn., vol. COM-16, pp. 340-344, Apr. 1968

6. Herrmann, O.
Transversalfilter zur Hilbert-Transformation
A.E.Ü. 23 (1969), 77-84

**Patentansprüche**

1. Empfangssystem, bestehend aus einem in analoger Technik realisierten Hochfrequenzteil mit Vorverstärker (VV), zwei in Quadratur betriebenen Mischern ($M_1$, $M_2$), einem $\pi/2$-Phasenschieber (Ph) und mit einem spannungsgesteuerten Oszillator (VCO), wobei das Hochfrequenzsignal durch Multiplikation mittels phasengeregelter Regelschleife direkt in das Basisband umgesetzt wird und den Mischern nachgeschaltete Tiefpässe ($TP_1$, $TP_2$) störende Mischprodukte selektieren und wobei die Basisbandsignale nach den Tiefpässen ($TP_1$, $TP_2$) abgetastet und über Analog-Digital-Wandler (A/D) geführt werden, sowie weiterhin bestehend aus einem dem Hochfrequenzteil nachgeschalteten digital realisierten Niederfrequenzteil, dadurch gekennzeichnet, dass die abgetasteten Basisbandsignale über die Analog-Digital-Wandler (A/D) je einem digitalen Ausgangstiefpass ($F_1$(z), $F_2$(z)) zugeführt werden, deren Ausgänge über einen Umschalter (S) wahlweise mit einem ausgangsseitigen Digital-Analog-Wandler (D/A) verbunden sind, und dass ferner in einem Zweig zwischen dem Analog-Digital-Wandler (A/D) und dem Ausgangstiefpass ($F_1$(z)) ein digitales Schleifenfilter (F(z)) eingefügt ist und dass am anderen Zweig zwischen dem Analog-Digital-Wandler (A/D) und dem Ausgangstiefpass ($F_2$(z)) eine Verstärkungsregelung ($F_R$(z), D/A) vorgesehen ist (Fig. 6).

2. Empfangssystem, bestehend aus einem in analoger Technik realisierten Hochfrequenzteil mit Vorverstärker (VV), zwei in Quadratur betriebenen Mischern ($M_1$, $M_2$), einem $\pi/2$-Phasenschieber (Ph) und mit einem spannungsgesteuerten Oszillator (VCO), wobei das Hochfrequenzsignal durch Multiplikation mittels phasengeregelter Regelschleife direkt in das Basisband umgesetzt wird und den Mischern nachgeschaltete Tiefpässe ($TP_1$, $TP_2$) störende Mischprodukte selektieren, sowie weiterhin bestehend aus einem dem Hochfrequenzteil nachgeschalteten digital realisierten Niederfrequenzteil, für Phasenumtastung ohne Träger (PSK) und Zweiseitenbandsignale ohne Träger, dadurch gekennzeichnet, dass das in das Basisband hinabgemischte Quadratursignal ($y_q$) mit einem weiteren Mischer ($M_3$) mit dem Nutzsignal ($y_i$) multipliziert wird, dass der Ausgang des weiteren Mischers ($M_3$) über ein Schleifenfilter (F(z)) und einen Digital-Analog-Wandler (D/A) mit dem spannungsgesteuerten Oszillator (VCO) verbunden ist, dass das Ausgangssignal vor dem Multiplizierer ($M_3$) aus dem Quadratur- oder aus dem IN-PHASE-ZWEIG abgegriffen und über einen Ausgangstiefpass ($F_A$(z)) zu einem ausgangsseitigen Digital-Analog-Wandler (D/A) geführt wird und dass das mit einem Tiefpass ($F_2$(z)) gefilterte Nutzsignal ($y_i$) nach einer Betragsbildung (B) einer Verstärkungsregelung ($F_R$(z), D/A) zugeführt wird (Fig. 7).

3. Empfangssystem, bestehend aus einem in analoger Technik realisierten Hochfrequenzteil mit Vorverstärker (VV), zwei in Quadratur betriebenen Mischern ($M_1$, $M_2$) einem $\pi/2$-Phasenschieber (Ph) und mit einem spannungsgesteuerten Oszillator (VCO), wobei das Hochfrequenzsignal durch Multiplikation mittels phasengeregelter Regelschleife direkt in das Basisband umgesetzt wird und den Mischern nachgeschaltete Tiefpässe ($TP_1$, $TP_2$) störende Mischprodukte selektieren, sowie weiterhin bestehend aus einem dem Hochfrequenzteil nachgeschalteten digital realisierten Niederfrequenzteil für Rest- und Einseitenbandsignale mit Träger, wobei das in dem Vorverstärker (VV) verstärkte Eingangssignal in zwei Zweige derart aufgespalten wird, dass der erste Zweig aus der Serienschaltung eines Mischers ($M_1$), eines Tiefpasses ($TP_1$), einer Abtasteinrichtung ($f_A$) mit nachfolgendem Analog-Digital-Wandler (A/D) besteht, mit einem spannungsgeregelten Oszillator (VCO), dessen Ausgangssignal ($x_0$) einerseits zum genannten Mischer ($M_1$) führt und andererseits über den die Phase um $\pi/2$ drehenden Phasenschieber (Ph) führt, dessen Ausgangssignal ($x_1$) zu dem im zweiten Zweig befindlichen Mischer ($M_2$) führt, dem ein Tiefpass ($TP_2$), eine Abtasteinrichtung ($f_A$) und ein Analog-Digital-Wandler (A/D) nachgeschaltet sind, und dass das hieran entstehende Ausgangssignal direkt dem Eingang eines Addierers (A) zugeführt wird, dadurch gekennzeichnet, dass das in dem Analog-Digital-Wandler entstehende Ausgangssignal des ersten Zweiges unter Einführung eines breitbandigen Hilbert-Transformators $\mathcal{H}$ dem anderen Eingang des Addierers (A) zugeführt wird, dessen Ausgang über einen gemeinsamen Ausgangstiefpass ($F_A$(z)) zu einem Analog-Digital-Wandler (D/A) führt, an dessen Ausgang das Nutzsignal abgreifbar ist, wobei am gemeinsamen Punkt des Analog-Digital-Wandlers (A/D) des zweiten Zweiges mit dem Addierer (A) eine Regelschleife

($F_R(z)$, D/A) zur Verstärkungsregelung angeschlossen ist und wobei der Ausgang des Analog-Digital-Wandlers (A/D) des ersten Zweiges über ein Schleifenfilter (F(z)) mit einem nachgeschalteten Digital-Analog-Wandler (D/A) mit dem spannungsgeregelten Oszillator (VCO) verbunden ist (Fig. 8).

4. Empfangssystem nach Anspruch 1, dadurch gekennzeichnet, dass die Verstärkungsregelung auf den Vorverstärker (VV) einwirkt.

5. Empfangssystem nach Anspruch 1, dadurch gekennzeichnet, dass die Verstärkungsregelung auf den spannungsgesteuerten Oszillator (VCO) einwirkt.

6. Empfangssystem nach Anspruch 1, dadurch gekennzeichnet, dass die Verstärkungsregelung auf die in den beiden Zweigen vorhandenen Tiefpässe ($TP_1$, $TP_2$) einwirkt.

7. Empfangssystem nach Anspruch 1, für zweiseitenbandamplitudenmodulierte Signale mit Träger, dadurch gekennzeichnet, dass die phasengerastete Regelschleife so schmalbandig ausgelegt ist, dass sie nur auf den — gegebenenfalls verrauschten — Träger synchronisiert, wobei das synchrondemodulierte Nutzsignal im IN-PHASE-ZWEIG am Ausgangstiefpass ($F_2(z)$) abgreifbar ist.

8. Empfangssystem nach Anspruch 1 für frequenzmodulierte Signale, dadurch gekennzeichnet, dass die phasengerastete Regelschleife so dimensioniert ist, dass sie sowohl den maximalen Frequenzhub ausregeln kann, als auch das Nutzsignal in seiner ganzen Bandbreite unverzerrt demoduliert, wobei das Nutzsignal im Phasenquadraturzweig am Ausgangstiefpass ($F_1(z)$), dessen Grenzfrequenz gleich der höchsten Niederfrequenz des demodulierten Nutzsignals ist, abgreifbar ist.

9. Empfangssystem nach Anspruch 3, dadurch gekennzeichnet, dass die Regelschleife auf den Vorverstärker (VV) einwirkt (Fig. 8).

10. Empfangssystem nach Anspruch 3, dadurch gekennzeichnet, dass die Regelschleife auf den spannungsgesteuerten Oszillator (VCO) einwirkt (Fig. 8).

11. Empfangssystem nach Anspruch 3, dadurch gekennzeichnet, dass die Spannungsregelung auf die in den beiden Zweigen vorhandenen Tiefpässe ($TP_1$, $TP_2$) einwirkt (Fig. 8).

## Claims

1. Receiving system consisting of a high frequency part realised in analog technique and with pre-amplifier (VV), two mixers ($M_1$, $M_2$) operated in quadrature, a $\pi/2$ phase shifter (Ph) and with a voltage-controlled oscillator (VCO), wherein the high frequency signal is translated directly into the base band through multiplication by means of phase-regulated regulating loop and low pass filters ($TP_1$, $TP_2$) connected behind the mixers select interfering modulation products and wherein the base band signals are scanned behind the low pass filters ($TP_1$, $TP_2$) and conducted through analog-to-digital converters (A/D), as well as further consisting of a low frequency part realised in digital technique and connected behind the high frequency part, characterised thereby, that the scanned base band signals are conducted through the analog-to-digital converters (A/D) to a respective output low pass filter ($F_1(z)$, $F_2(z)$), the outputs of which are connected through a change-over switch selectably with a digital-to-analog converter (D/A) at the output side, and that furthermore a digital loop filter (F(z)) is inserted in one branch between the analog-to-digital converter (A/D) and the output low pass filter ($F_1(z)$) and that an amplification regulation ($F_R(z)$, D/A) is provided at the other branch between the analog-to-digital converter (A/D) and the output low pass filter ($F_2(z)$) (Fig. 6).

2. Receiving system consisting of a high frequency part realised in analog technique and with pre-amplifier (VV), two mixers ($M_1$, $M_2$) operated in quadrature, a $\pi/2$ phase shifter (Ph) and with a voltage-controlled oscillator (VCO), wherein the high frequency signal is translated directly into the base band through multiplication by means of phase-regulated regulating loop and low pass filters ($TP_1$, $TP_2$) connected behind the mixers select interfering modulation products as well as further consisting of a low frequency part realised in digital technique and connected behind the high frequency part, for phase-switching without carrier (PSK) and double sideband signals without carrier, characterised thereby, that the quadrature signal ($y_q$) mixed down into the base band is multiplied with the useful signal ($y_i$) by a further mixer ($M_3$), that the output of the further mixer ($M_3$) is connected through a loop filter (F(z)) and a digital-to-analog converter (D/A) with the voltage-controlled oscillator (VCO), that the output signal is tapped off before the multiplier ($M_3$) from the quadrature branch or from the in-phase branch and conducted through an output low pass filter ($F_A(z)$) to a digital-to-analog converter (D/A) at the output side and that the useful signal ($y_i$) filtered by a low pass filter ($F_2(z)$) is conducted after a quantisation (B) to an amplification regulation ($F_R(z)$, D/A) (Fig. 7).

3. Receiving system consisting of a high frequency part realised in analog technique and with pre-amplifier (VV), two mixers ($M_1$, $M_2$) operated in quadrature, a $\pi/2$ phase shifter (Ph) and with a voltage-controlled oscillator (VCO), wherein the high frequency signal is translated directly into the base band through multiplication by means of phase-regulated regulating loop and low pass filters ($TP_1$, $TP_2$) connected behind the mixers select interfering modulation products, as well as further consisting of a low frequency part realised in digital technique and connected behind the high frequency part, for residual signals and single sideband signals with carrier, wherein the input signal amplified in the pre-amplifier (VV) is split up into two branches in such a manner that the first branch consists of the series connection of a mixer ($M_1$), a low pass filter ($TP_1$), a scanning equipment ($f_A$) with following analog-to-digital converter (A/D), with a voltage-regulated oscillator (VCO), the output signal ($x_0$) of which leads on the one hand to the named mixer ($M_1$) and on the other hand through the phase shifter (Ph), which rotates the phase through $\pi/2$ and the output signal ($x_1$) of which leads to the mixer ($M_2$), which is disposed in the second branch and behind which are connected a low pass filter ($TP_2$), a scanning equipment ($f_A$) and an analog-to-digital converter (A/D), and that the output signal arising hereat is conducted directly to the input of an adder (A), characterised thereby, that the output signal of the first branch arising in the analog-to-digital converter is conducted with the insertion of a wide band Hilbert transformer $H$ to the other input of the adder (A), the output of which leads through a common output low pass filter ($F_A(z)$) to an analog-to-digital converter (D/A), at the output of which the useful signal is derivable, wherein a regulating loop ($F_R(z)$, D/A) for amplification regulation is connected at the common point of the analog-to-digital converter (A/D) of the second branch with the adder (A) and wherein the output of the analog-to-digital converter (A/D) of the first branch is connected through a loop filter (F(z)) with a digital-to-analog converter (D/A) connected therebehind to the voltage-controlled oscillator (VCO) (Fig. 8).

4. Receiving system according to claim 1, characterised thereby, that the amplification regulation acts on the pre-amplifier (VV).

5. Receiving system according to claim 1, characterised thereby, that the amplification regulation acts on the voltage-controlled oscillator (VCO).

6. Receiving system according to claim 1, characterised thereby, that the amplification regulation acts on the low pass filters ($TP_1$, $TP_2$) present in both the branches.

7. Receiving system according to claim 1, for double sideband, amplitude-modulated signals with carrier, characterised thereby, that the phase-locked regulating loop is designed to be of such narrow bandwidth that it synchronises only to the possibly noisy carrier, wherein the synchronously demodulated useful signal is derivable at the output low pass filter ($F_2(z)$) in the in-phase branch.

8. Receiving system according to claim 1, for frequency-modulated signals, characterised thereby, that the phase-locked regulating loop is so dimensioned that it can regulate out the maximum frequency shift as well as demodulates the useful signal without distortion in its entire bandwidth, wherein the useful signal is derivable in the phase quadrature branch at the output low pass filter ($F_1(z)$), the limit frequency of which is equal to the highest low frequency of the demodulated useful signal.

9. Receiving system according to claim 3, characterised thereby, that the regulating loop acts on the pre-amplifier (VV) (Fig. 8).

10. Receiving system according to claim 3, characterised thereby, that the regulating loop acts on the voltage-controlled oscillator (VCO) (Fig. 8).

11. Receiving system according to claim 3, characterised thereby, that the regulating loop acts on the low pass filters ($TP_1$, $TP_2$) present in both the branches (Fig. 8).

## Revendications

1. Système de réception constitué par une partie haute fréquence réalisée en technique analogique avec un préamplificateur (VV), deux mélangeurs fonctionnant en quadrature ($M_1$, $M_2$), un déphaseur $\pi/2$ (Ph) et un oscillateur contrôlé par tension (VCO), le signal haute fréquence étant transposé directement dans la bande de base par multiplication à l'aide d'une boucle de régulation à verrouillage de phase, les filtres passe-bas ($TP_1$, $TP_2$) montés en aval des mélangeurs sélectant les produits de mélange gênants, et les signaux en bande de base étant échantillonnés en aval des filtres passe-bas ($TP_1$, $TP_2$), puis appliqués à des convertisseurs analogiques-numériques (A-N), ainsi que par une partie basse fréquence réalisée en technique numérique et disposée en aval de la partie haute fréquence, ledit système étant caractérisé en ce que les signaux en bande de base échantillonnés sont appliqués par les convertisseurs analogiques-numériques (A-N) chacun à un filtre passe-bas de sortie numérique ($F_1(z)$), dont les sorties sont reliées au choix par un inverseur (S) à un convertisseur numérique-analogique (N-A) de sortie; un filtre de boucle numérique (F(z)) est inséré dans une branche, entre le convertisseur analogique-numérique (A-N) et le filtre passe-bas de sortie ($F_1(z)$); et un contrôle du gain ($F_1(z)$, N-A) est prévu dans la seconde branche, entre le convertisseur analogique-numérique (A-N) et le filtre passe-bas de sortie ($F_2(z)$) (fig. 6).

2. Système de réception constitué par une partie haute fréquence réalisée en technique analogique, avec un préamplificateur (VV), deux mélangeurs fonctionnant en quadrature ($M_1$, $M_2$), un déphaseur $\pi/2$ (Ph) et un oscillateur contrôlé par tension (VCO), le signal haute fréquence étant transposé directement en bande de base par multiplication à l'aide d'une boucle de régulation à verrouillage de phase et les filtres passe-bas ($TP_1$, $TP_2$) montés en aval des mélangeurs éliminant les produits de mélange gênants, ainsi que par une partie basse fréquence réalisée en technique numérique et montée en aval de la partie haute fréquence, pour la modulation de phase sans porteuse (PSK) et signaux à double bande latérale sans porteuse, ledit système étant caractérisé en ce qu'un autre mélangeur ($M_3$) multiplie le signal en quadrature ($y_q$) abaissé par mélange dans la bande de base par le signal utile ($y_i$); la sortie du mélangeur supplémentaire ($M_3$) est reliée par un filtre de boucle (F(z)) et un convertisseur numérique-analogique (N-A) à l'oscillateur contrôlé par tension (VCO); le signal de sortie est prélevé sur la branche en quadrature ou en phase, en amont du

multiplicateur ($M_3$), puis appliqué par un filtre passe-bas de sortie ($F_A(z)$) à un convertisseur numérique-analogique de sortie (N-A); et le signal ($y_i$) filtré par un filtre passe-bas ($F_2(z)$) est appliqué, après formation de la valeur absolue (B), à une régulation de gain ($F_R(z)$, N-A) (fig. 7).

3. Système de réception constitué par une partie haute fréquence, réalisé en technique analogique avec un préamplificateur (VV), deux mélangeurs fonctionnant en quadrature ($M_1$, $M_2$), un déphaseur $\pi/2$ (Ph) et un oscillateur contrôlé par tension (VCO), le signal haute fréquence étant transposé directement dans la bande de base par multiplication à l'aide d'une boucle de régulation à verrouillage de phase et les filtres passe-bas ($TP_1$, $TP_2$) montés en aval des mélangeurs sélectant les produits de mélange gênants, ainsi que par une partie basse fréquence réalisée en technique numérique et montée en aval de la partie haute fréquence, pour des signaux à bande latérale résiduelle ou à bande latérale unique et porteuse, le signal d'entrée amplifié par le préamplificateur (VV) étant divisé en deux branches de façon que la première soit constituée par le branchement en série d'un mélangeur ($M_1$), d'un filtre passe-bas ($TP_1$), d'un échantillonneur ($f_A$) avec convertisseur analogique-numérique (A-N) en aval et d'un oscillateur contrôlé par tension (VCO), dont le signal de sortie ($x_o$) est appliqué d'une part au mélangeur précité ($M_1$) et d'autre part au déphaseur $\pi/2$ (Ph) dont le signal de sortie ($x_1$) est appliqué au mélangeur ($M_2$) se trouvant dans la seconde branche, en amont d'un filtre passe-bas ($TP_2$), d'un échantillonneur ($f_A$) et d'un convertisseur analogique-numérque (A-N); et le signal de sortie ainsi obtenu est appliqué directement à l'entrée d'un additionneur (A), ledit système étant caractérisé en ce que le signal de sortie produit par le convertisseur analogique-numérique est appliqué, avec insertion d'un transformateur de Hilbert ℋ à large bande, à la seconde entrée de l'additionneur (A), dont la sortie est reliée par un filtre passe-bas de sortie ($F_A(z)$) commun à un convertisseur numérique-analogique (N-A) sur la sortie duquel le signal utile est prélevé, une boucle de régulation du gain ($F_R(z)$, N-A) étant reliée au point commun du convertisseur analogique-numérique (A·N) de la seconde branche et de l'additionneur (A), et la sortie du convertisseur analogique-numérique (A-N) de la première branche étant reliée par un filtre de boucle ($F(z)$) avec un convertisseur numérique-analogique (N-A) en aval à l'oscillateur contrôlé par tension (VCO) (fig. 8).

4. Système de réception selon la revendication 1, caractérisé en ce que la régulation du gain agit sur le préamplificateur (VV).

5. Système de réception selon la revendication 1, caractérisé en ce que la régulation du gain agit sur l'oscillateur contrôlé par tension (VCO).

6. Système de réception selon la revendication 1, caractérisé en ce que la régulation du gain agit sur les filtres passe-bas ($TP_1$, $TP_2$) dans les deux branches.

7. Système de réception selon la revendication 1 pour signaux modulés en amplitude, à double bande latérale et porteuse, caractérisé en ce que la largeur de bande de la boucle de régulation à verrouillage de phase est dimensionnée à une valeur suffisamment faible pour ne synchroniser que sur la porteuse bruyante le cas échéant, le signal utile étant prélevé après démodulation synchrone dans la branche en phase, sur le filtre passe-bas de sortie ($F_2(z)$).

8. Système de réception selon la revendication 1 pour signaux modulés en fréquence, caractérisé en ce que la boucle de régulation à verrouillage de phase est dimensionnée de façon à pouvoir compenser l'excursion de fréquence maximale et à démoduler sans distorsion le signal utile sur toute sa largeur de bande, le signal utile étant prélevé dans la branche en quadrature, sur le filtre passe-bas de sortie ($F_1(z)$), dont la fréquence de coupure est égale à la basse fréquence maximale du signal utile démodulé.

9. Système de réception selon la revendication 3, caractérisé en ce que la boucle de régulation agit sur le préamplificateur (VV) (fig. 8).

10. Système de réception selon la revendication 3, caractérisé en ce que la boucle de régulation agit sur l'oscillateur contrôlé par tension (VCO) (fig. 8).

11. Système de réception selon la revendication 3, caractérisé en ce que la régulation de tension agit sur les filtres passe-bas ($TP_1$, $TP_2$) situés dans les deux branches (fig. 8).

0 062 872

FIG.1

$$f_A = \frac{1}{m}[\omega_m \pm B/2] \geqslant 2B \qquad m\varepsilon\ Z$$

FIG.2

FIG.5

11

FIG. 3

FIG. 4

FIG. 6

FIG.7

FIG. 8

breitbandiger
Hilberttransf.

Verstärkungsregelung